# EUROPÄISCHE PATENTSCHRIFT

(11) **EP 3 507 612 B1**
(45) Veröffentlichungstag und Bekanntmachung des Hinweises auf die Patenterteilung: **07.06.2023**
(21) Anmeldenummer: 17740377.1
(22) Anmeldetag: 14.07.2017
(51) Int. Cl.: G01R 31/34, H02K 11/27, H02P 21/20

(54) **VORRICHTUNG ZUR DIAGNOSE EINER MITTELS EINES ELEKTRISCHEN ANTRIEBSMOTORS ANGETRIEBENEN MECHANISCHEN ANLAGE**
DEVICE FOR DIAGNOSING A MECHANICAL SYSTEM WHICH IS DRIVEN BY MEANS OF AN ELECTRIC DRIVE MOTOR
DISPOSITIF POUR ÉTABLIR LE DIAGNOSTIC D'UNE INSTALLATION MÉCANIQUE ENTRAÎNÉE AU MOYEN D'UN MOTEUR DE COMMANDE ÉLECTRIQUE

(30) Priorität: 27.07.2016 DE 102016213766
(43) Veröffentlichungstag der Anmeldung: 10.07.2019
(73) Patentinhaber: Deutsche Bahn AG, 10785 Berlin (DE)
(72) Erfinder: NEUJAHR, Gerd, 64668 Rimbach (DE)
(86) Internationale Anmeldenummer: PCT/EP2017/067890
(87) Internationale Veröffentlichungsnummer: WO 2018/019619

(56) Entgegenhaltungen:
- WO-A1-01/85523
- DE-A1-102010 043 254
- JP-A- 2005 354 881
- US-A- 3 621 392
- US-A- 5 514 978

## Beschreibung

Die Erfindung betrifft eine Vorrichtung zur Diagnose einer mittels eines elektrischen Antriebsmotors angetriebenen mechanischen Anlage, umfassend mindestens einen Sensor zur Erfassung des Stromverlaufes in einem Leiter des elektrischen Anschlusses des Antriebsmotors sowie Sensoren zur Erfassung der Spannungsverläufe in den Leitern des elektrischen Anschlusses des Antriebsmotors, wobei jedem Leiter jeweils ein Sensor zur Erfassung des Stromverlaufes sowie ein Sensor zur Erfassung des Spannungsverlaufes zugeordnet sind. Dabei kann der elektrische Antrieb mit Gleichstrom, Wechselstrom oder Dreiphasen-Wechselstrom gespeist werden.

Derartige Diagnose-Vorrichtungen sind aus dem Stand der Technik bekannt. Deren Aufgabe besteht darin, die korrekte Funktionsfähigkeit der mechanischen Anlage zu überwachen und dabei insbesondere Schwergängigkeiten in den von den Motoren angetriebenen mechanischen Anlagen zu erkennen. So würde sich beispielsweise eine durch Verschleiß oder unzureichende Justierung hervorgerufene Schwergängigkeit in einer mechanischen Anlage dadurch bemerkbar machen, dass sich der Stromverbrauch des Antriebsmotors im Vergleich zu einem Soll-Zustand verändert (d.h. in aller Regel erhöht). Es wird also der Stromverlauf während eines vollständigen Antriebszyklus - also vom Anfahren bis zum nachfolgenden Stillstand des Antriebsmotors - als Kriterium für den mechanischen Zustand des mechanischen Systems herangezogen. Wenn im Vergleich zu den Referenzwerten eines ordnungsgemäßen Zustandes der Stromverbrauch des Antriebsmotors höher ist oder sich zwischen zwei mit zeitlichem Abstand aufeinander folgenden Antriebszyklen verschlechtert (d.h. zu höheren Werten verschiebt), so wird davon ausgegangen, dass die höhere Stromaufnahme in einem direkten Zusammenhang mit der Bewegung der vom Motor angetriebenen mechanischen Anlage steht. Ein zunehmender Stromverbrauch stellt also ein Indiz für die Schwergängigkeit der mechanischen Anlage sowie für deren zunehmenden Wartungs- und / oder Instandhaltungsbedarf dar. Derartige Diagnose-Vorrichtungen kommen insbesondere bei Antriebssystemen zum Einsatz, die durch eine Vielzahl sich wiederholender Ablaufzyklen geprägt sind, wie es z.B. bei einem reversierenden Betrieb zwischen zwei Zuständen der Fall ist. Ein typisches Beispiel hierfür sind Weichen-Stellantriebe.

Die DE 37 15 478 A1 beschreibt eine Schaltungsanordnung zur Überwachung eines Weichenantriebs, der mittels einer 4-Draht-Schaltung über ein Drehstromnetz versorgt wird. In den jeweiligen Leitern der 4-Draht-Schaltung sind Leitungsschalter und Stromüberwacher angeordnet. Beim motorisch angetriebenen Umlaufen der Weiche von einer ersten in eine zweite Stellung wird der Stromfluss in den Stromüberwachern gemessen und hieraus ein Bitmuster ermittelt, anhand dessen Aussagen über den Zustand der Weiche möglich sein sollen. Allerdings kann mit einer solchen Vorrichtung nur das Erreichen der Endlagen des motorisch angetriebenen Stellsystems überwacht werden. Eine eventuelle Schwergängigkeit des Antriebssystems wird nicht erkannt, solange diese nicht das Erreichen einer Endlage verhindert.

Aus der WO 2008/089502 A2 ist eine Vorrichtung bekannt, welche den Energiebedarf eines Drehstrom-Weichenantriebsmotors ermittelt, woraus dann wiederum auf den Zustand der Weiche geschlossen werden kann. Die Ermittlung des Energiebedarfes erfolgt über die näherungsweise Messung des Wirkstrom-Anteils in einem Leiter des Antriebsmotors mittels einer parallel zum Leiter geschalteten Drossel, wobei der an die Drossel angeschlossene Leiter entgegengesetzt zum jeweiligen Leiter durch einen einachsigen Hall-Sensors geführt ist.

Aus der DE 10 2014 223 234 B3 ist schließlich eine gattungsgemäße Diagnose-Vorrichtung bekannt, welche das Magnetfeld eines Leiters mittels eines den Leiter umgreifenden mehrdimensionalen Hall-Sensors ermittelt, und auf diese Weise den Stromverlauf im jeweiligen Leiter des Weichenantriebs misst. Dabei wird an mindestens zwei verschiedenen Leitern der jeweilige Stromverlauf in jedem dieser Leiter gemessen. Durch Abgleich von an zwei verschiedenen Leitern ermittelten Messwerten kann die Drehrichtung des Weichenantriebsmotors ermittelt werden. Zusätzlich kann durch Abgleich aktueller an einem Leiter gewonnener Messwerte mit früheren Messwerten desselben Leiters eine Aussage über die Entwicklung der Schwergängigkeit der Weiche getroffen werden. Derartige mehrdimensionale Magnetfeld-Sensoren sind in der Lage, auch die nicht senkrecht auf den Sensor treffenden Anteile des (durch den im Leiter des Antriebsmotors fließenden Strom erzeugten) Magnetfelds zu messen. Weiters sind derartige Sensoren nach Art einer Mess-Strippe unmittelbar auf den jeweiligen Leiter aufbringbar und können somit sehr platzsparend und ohne Eingriff in die bestehende Verkabelung nachgerüstet werden.

Allerdings kann mit diesen vorbekannten Vorrichtungen nur eine sich in zeitlicher Hinsicht verändernde Schwergängigkeit detektiert werden, ohne dass eine genauer spezifizierende Diagnose über die mögliche Ursache dieser Schwergängigkeit möglich wäre. Insbesondere weil derartige Messungen, Stromkurven über der Zeitachse aufzeichnen, ist eine Segmentierung der Stromkurve bezogen auf den mechanischen Weg schwierig und lassen keine detaillierten Diagnosen über den exakten Ort der Schwergängigkeit im mechanischen Ablauf zu. Somit ist es im Zuge der laufenden Instandhaltung erforderlich, das mechanische Gesamtsystem vor Ort zu analysieren und Schadenssuche zu betreiben.

JP 2005 354881 A offenbart eine Steuerung von Schutzvorrichtungen in elektrischen Verteilsystemen, bei der Strom- und Spannungswerte sensorisch erfasst und einer Auswertungseinrichtung zugeführt werden, welche bei Vorliegen eines Kurzschlusses einen Schutzschalter betätigt.

US 5,514,978 A offenbart eine Vorrichtung zur Diagnose von Wicklungsfehlern in Asynchronmotoren, bei der sowohl der Stromverlauf als auch der Spannungsverlauf in den Leitern des elektrischen Anschlusses des Asynchronmotors gemessen werden. Hierauf basierend werden durch Berechnung der Induktivität Rückschlüsse auf das elektrische Verhalten des Motors und insbesondere dessen Wicklungen gezogen.

WO 01/85523 A1 behandelt einen Messaufbau zur kontaktgebundenen Spannungsmessung, der für einen Betriebszustand "Aus" von zu messenden Leitungen entkoppelt werden kann. Die Ein- bzw. Entkopplung erfolgt über eine Relaisschaltung, die mittels Hallsensor und Verstärker geschaltet wird. Sobald Strom durch die zu messende Leitung und somit auch durch den Hallsensor fließt, werden die Relais und somit auch die Spannungsmessung eingeschaltet.

Mittels solcher Spannungssensoren können die elektrischen Felder individuell in jedem Leiter des Antriebsmotors auch bidirektional erfasst werden. Neben den Amplituden können damit insbesondere auch die Nulldurchgänge der Spannungsverläufe in jedem Leiter erfasst werden. Eine solche messtechnisch eindeutige Erfassung der Nulldurchgänge der sinusförmigen Spannungsverläufe in den Leitern des Antriebsmotors ermöglicht die exakte Bestimmung der Einschalt- und Abschaltzeitpunkte der Messung und ist damit auch die Grundlage für eine korrekte Segmentierung des Wirkstromverlaufes eines Umstellvorgangs. Zusätzlich sind in den Spannungsverläufen Schaltvorgänge wie zum Beispiel Stern-Dreieck-Umschaltung oder Schaltvorgänge in der 4-Draht-Schaltung bei Weichenantrieben sichtbar und können als weitere Fixpunkte in der Segmentierung des Wirkstromverlaufs eines Umstellvorgangs verwendet werden.

In vorbekannten Diagnosesystemen wurde die Zuordnung zwischen den gemessenen Stromverläufen in den Leitern und den tatsächlichen funktionalen Stadien der angetriebenen mechanischen Anlage allerdings in aller Regel anhand eines deterministischen, auf Erfahrungswissen basierenden Schemas vorgenommen. Derartige Diagnosesysteme basieren also auf einer mehr oder weniger empirisch gewonnenen Annahme, dass die verschiedenen funktionalen Stadien bzw. Zustände einer mechanischen Anlage während des zeitlichen Verlaufes eines Antriebszyklus einen jeweils fest definierten zeitlichen Abstand zum Anlaufen des Antriebsmotors zum Einsatz aufweisen (d.h. immer nach Ablauf derselben Zeitspanne nach Anlaufen des Antriebsmotors starten). Eine solche auf hypothetischen Annahmen basierende Diagnose kann aber nur ungenaue und vergleichsweise unspezifische Ergebnisse liefern, da kein Abgleich mit den realen an der Anlage stattfindenden Funktionsabfolgen erfolgt. Es leuchtet ein, dass gerade bei zunehmender Schwergängigkeit der mechanischen Anlage die realen Funktionsabläufe von den ursprünglichen, in einem "nicht-schwergängigen" Zustand ermittelten zeitlichen Abfolgen nahezu zwangsläufig abweichen müssen. Es blieb bei vorbekannten Messmethoden unberücksichtigt, dass asynchrone Drehstrommotoren bei höherer Belastung eine geringere Drehzahl aufweisen, wodurch sich die realen mechanischen Funktionsabläufe verlangsamen.

Erschwerend kommt hinzu, dass bei der aus dem Stand der Technik vorbekannten Messung der Stromverläufe in den Leitern mittels Hall-Sensoren keine exakten Einschalt- und Abschaltzeitpunkte ermittelbar sind. Im vorbekannten Stand der Technik muss der gemessene Strom erst eine gewisse Zeit am Datenlogger anliegen, um die Messung zu starten. Ein solchermaßen generierter Beginn der Messung ist aber nicht identisch mit dem tatsächlichen Einschalten des Antriebs.

Aber auch andere Ansätze, die auf die Anwendung mathematischer Filter auf die Wirkstromverläufe abzielen, haben sich als ungeeignet erwiesen.

US 3 621 392 A offenbart eine Vorrichtung zum Messen des Auqenblickswerts der in einem elektrischen Leiter fließenden Leistung. Dabei erfolgt die Strommessung mittels einer Spule, in der ein Strom induziert wird. Die Spannung wird durch das elektrische Feld zwischen Leiter und Erdpotential repräsentiert.

Die exakte Messung des Phasenverschiebungswinkels ϕ zwischen Strom und Spannung erlaubt die exakte Aufzeichnung einer cos ϕ - Kurve und die Berechnung des exakten Wirkstromanteils, der mit der mechanischen Schwergängigkeit der angetriebenen Anlage korrespondiert. Die hierdurch erzielten Verbesserungen bei der Genauigkeit und beim Detaillierungsgrad der Ermittlung des Wirkstroms führen zu einer Verbesserung der hierauf basierenden Diagnose. Im Ergebnis können Störungen an der mechanischen Anlage durch die mittels der erfindungsgemäßen Vorrichtung gewonnenen Daten zuverlässiger vermieden werden. Eine genauere Diagnose führt zu einem effizienteren und zielgerichteten Einsatz des auf die Diagnose reagierenden Instandhaltungspersonals. Darüber hinaus liefert die Erfindung die exakten Anteile von Wirkstrom, Blindstrom und Scheinstrom sowie die zugehörigen Kurven der Leistungsfaktoren. Die Langzeitbeobachtung dieser Werte erlaubt eine zuverlässige Motordiagnose. Für Motoren, deren Werte symmetrisch sind und sich stationär verhalten, besteht keine Gefahr eines kurzfristigen Ausfalls.

Beim Stand der Technik ist der permanente Betrieb der Sensoren und der Datalogger erforderlich. Die zu diagnostizierenden mechanischen Anlagen mit sich wiederholenden Vorgängen wie zum Beispiel Tore, oder Weichen sind in der Regel nicht permanent in Betrieb. Durch die erfindungsgemäße und messtechnisch eindeutige Erfassung der Nulldurchgänge der sinusförmigen Spannungsverläufe in den Leitern des Antriebsmotors wird auch eine selbsttätige Steuerung der Vorrichtung ermöglicht. Hierzu werden die Signale der Spannungs-Sensoren einer Auswerteeinheit zugeführt. Sobald diese ein sinusförmiges elektrisches Feld erkennt, wird die Vorrichtung aktiviert. Auf diese Weise kann für die Diagnose-Vorrichtung ein energiesparender Stand-By-Modus realisiert werden.

Darüber hinaus ist aber auch eine externe Triggerung der Messungen realisierbar, wie sie beispielsweise bei permanent laufenden Antriebsmotoren sinnvoll sein kann. Hierzu wird die vom Antriebsmotor angetriebene mechanische Anlage mit einem Triggerpunkt versehen, über dessen sensorisches Erkennen ein Startsignal für den Beginn der Messung sowie - nach beispielsweise einem Komplett-Umlauf der motorisch angetriebenen mechanischen Anlage - ein Stopp-Signal für das Beenden der Messung generiert wird. Eine erfindungsgemäße Diagnosevorrichtung in Verbindung mit permanent laufenden Antriebsmotoren ist beispielsweise bei Rolltreppen oder ähnlichen, im dauerhaften Ein-Richtungsbetrieb laufenden Förderanlagen sinnvoll.

DE 10 2010 043 254 A1 offenbart ein Messsystem zur Überwachung mindestens einer Phase eines elektrischen Verbrauchers, bei dem mittels Strom- und kapazitiven Spannungssensoren die Strom- und Spannungswerte der Phase ermittelt werden, wobei eine Messung der Phasenspannung gegen das Erdpotential erfolgt.

Die aus dem Stand der Technik vorbekannten Verfahren bzw. Vorrichtungen basieren somit stets darauf, dass die Spannungsmessung in den einzelnen Phasenleitern in kontaktbehafteter Weise gegen ein Bezugspotential erfolgt, bei dem es sich in aller Regel um das Erdpotential handelt. Solche Verfahren sind nicht anwendbar in räumlichen Umgebungen, die z.B. zur Vermeidung unerwünschter Rückkopplungen und Beeinflussungen der elektrischen Anlage potentialfrei bzw. rückwirkungsfrei sein müssen. Dies ist beispielsweise in Eisenbahn-Stellwerken der Fall.

Die Aufgabe der vorliegenden Erfindung besteht somit darin, eine Vorrichtung zur Diagnose einer mittels eines elektrischen Antriebsmotors angetriebenen mechanischen Anlage, umfassend mindestens einen Sensor zur Erfassung des Stromverlaufes in einem Leiter des elektrischen Anschlusses des Antriebsmotors sowie Sensoren zur Erfassung der Spannungsverläufe in den Leitern des elektrischen Anschlusses des Antriebsmotors bereitzustellen, wobei jedem Leiter jeweils ein Sensor zur Erfassung des Stromverlaufes sowie ein Sensor zur Erfassung des Spannungsverlaufes zugeordnet sind, welche in räumlichen Umgebungen anwendbar ist, in denen eine Rückwirkungsfreiheit gegenüber anderen elektrischen Einrichtungen und Erdfreiheit als Schutz gegen versehentliche Berührung zu gewährleisten ist.

Dies wird erfindungsgemäß dadurch erreicht, dass die Sensoren zur Erfassung der Spannungsverläufe in den Leitern als berührungslose Sensoren zur Erfassung des elektrischen Feldes im jeweiligen Leiter ausgeführt sind und die Vorrichtung des Weiteren einen Sensor zur Erfassung des summarischen elektrischen Feldes aller drei Leiter eines elektrischen Anschlusses eines Dreiphasen-Antriebsmotors aufweist. Ein solcher Sensor addiert die elektrischen Felder aller drei Leiter des Antriebsmotors zu einem Summenwert. Auf diese Weise wird innerhalb der Diagnosevorrichtung ein spezifischer Bezugspunkt zur Messung und Bewertung der elektrischen Felder der Leiter geschaffen. Diese Messmethode eignet sich besonders zur Messung von Dreiphasen-Wechselspannung, da die Summe der drei Sinuswerte Null ergibt.

Hierdurch entfällt das aufwändige rückwirkungsfreie Heranführen eines externen Bezugspotentials, z.B. über die Stromversorgung der Diagnosevorrichtung, welches bedingt durch die Leitungswege störungsbehaftet ist. Hierbei wird der exakte zeitliche Sinusverlauf der Spannungen gemessen. Ein solcher Sensor kann sehr einfach ausgeführt sein, z.B. in Form eines elektrisch leitenden Plättchens oder Drahtes auf dem sich die elektrische Ladung durch das elektrische Feld verschiebt. Diese als Influenz bezeichnete Ladungsverschiebung wird messtechnisch erfasst und ausgewertet. Der Messaufbau der erfindungsgemäßen Vorrichtung liefert den exakten Sinusverlauf mit den Zeitpunkten von û (U-Dach - Scheitelwert) und den Nulldurchgängen der gemessenen Spannungen.

Darum kann bei einer erfindungsgemäßen Diagnosevorrichtung die Versorgungsspannung aus einer unabhängigen, potentialfreien Quelle stammen. Beispielsweise kämen eine Batterie, eine Solarzelle oder ein durch einen Trenntrafo galvanisch getrenntes Labor-Netzteil als Spannungsquelle in Betracht. Die solchermaßen erreichte Unabhängigkeit von jeglichem Bezugspotential eröffnet auch die Möglichkeit zur Nutzung von Funk- und LWL- Schnittstellen.

Die Erfindung umfasst auch die Diagnose von Antriebssystemen für Schienenweichen oder Förderanlagen, jeweils umfassend mindestens einen elektrisch betrieben Antriebsmotor sowie eine gemäß der vorgenannten Merkmale ausgeführte Vorrichtung zur Diagnose.

Die vorliegende Erfindung wird nachfolgend anhand eines Ausführungsbeispiels und der dazugehörigen Zeichnung näher erläutert.

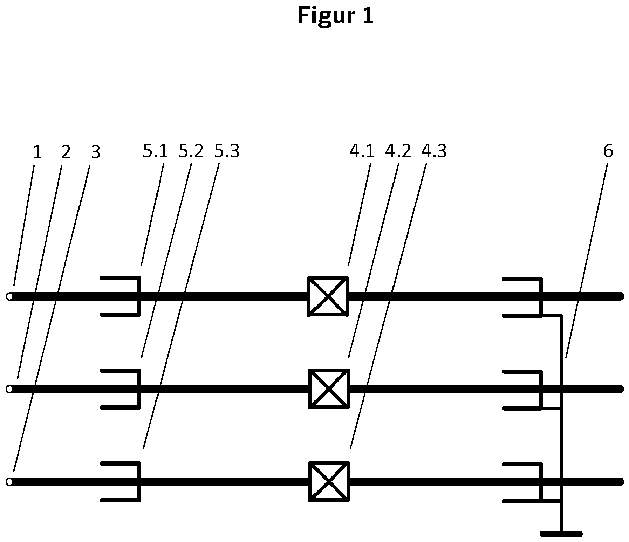

Figur 1 zeigt eine schematische Darstellung des Messaufbaus einer erfindungsgemäßen Diagnose-Vorrichtung, wobei der Antriebsmotor und die von diesem angetriebenen mechanischen Anlage aus Gründen der besseren Übersichtlichkeit nicht in Figur 1 dargestellt sind. Deren konkrete Ausführung entspricht dem üblichen Stand der Technik und ist für das Verständnis der Erfindung auch nicht weiter relevant. Die Vorrichtung ist zur Aufnahme von maximal drei Motor-Anschlussleitungen, den Leitern (1, 2, 3) konzipiert. An jedem einzelnen Leiter (1, 2, 3) ist jeweils ein Hall-Sensor (4.1, 4.2, 4.3) angebracht, der den Stromverlauf im jeweiligen Leiter messtechnisch erfasst. Ferner ist an jedem einzelnen Leiter (1, 2, 3) ein Sensor (5.1, 5.2, 5.3) zur Erfassung des elektrischen Feldes des Leiters angebracht, welcher den Spannungsverlauf im jeweiligen Leiter messtechnisch erfasst. Des Weiteren ist ein zusätzlicher Sensor (6) zur Erfassung des elektrischen Feldes vorhanden. Dieser Sensor erfasst das summarische elektrische Feld der Leiter (1, 2, 3) und generiert das Bezugspotential für die Spannungsmessung. Die Einzel-Sensoren (5.1, 5,2, 5.3) werden gegen den Summen-Sensor (6) gemessen. Sämtliche Sensoren, auch die Hall-Sensoren (4.1, 4.2, 4.3) sind zur bipolaren Erfassung der jeweiligen magnetischen oder elektrischen Felder eingerichtet, d.h. zur Messung des sinusförmigen Verlaufes der jeweiligen Feldstärke inklusive deren Nulldurchgänge. Die Einzel-Sensoren (5.1, 5.2, 5.3) messen die elektrischen Felder eines jeden Leiters (1, 2, 3), welche synchron zum sinusförmigen Spannungsverlauf im jeweiligen Leiter verlaufen. Die Hall-Sensoren (4.1, 4.2, 4.3) messen die magnetischen Felder eines jeden Leiters (1, 2, 3), welche synchron zum sinusförmigen Stromverlauf im jeweiligen Leiter verlaufen. Eventuelle Laufzeitunterschiede, die durch die unterschiedlichen Messprinzipien verursacht sind, werden im Zuge der Signalauswertung mathematisch kompensiert. Im Ergebnis dieser Messungen werden die Nulldurchgänge der Spannungs- und Stromverläufe in jedem Leiter ermittelt. Aus den zeitlichen Differenzen dieser Nulldurchgänge sind die Phasenwinkel ϕ ermittelbar, die über den gesamten Messvorgang aufgezeichnet werden. Die so aufgezeichnete cos ϕ-Kurve reagiert sehr empfindlich auf Änderungen der mechanischen Belastung und kann zusammen mit der Wirkstromkurve die Diagnose verbessern. Des Weiteren werden Schaltvorgänge in der cos ϕ-Kurve angezeigt, wie sie bei der Stern-Dreieck-Schaltung oder der 4-Draht-Weichenschaltung zur Steuerung und Überwachung verwendet werden. Diese Schaltvorgänge können als Fixpunkte zur Segmentierung des mechanischen Ablaufs verwendet werden.

Das mit den Spannungssensoren gemessene elektrische Feld, reagiert sehr empfindlich auf Störungen in der Spannungsversorgung. Prellende Kontakte oder kurze Spannungsunterbrechungen durch defekte Schalteinrichtungen werden zuverlässig erkannt.

Somit liefert die Vorrichtung Daten, die in Verbindung mit einem Diagnosesystem zur Überwachung und Diagnose der Schalteinrichtung, des elektrischen Antriebs und der mechanischen Anlage verwendet werden können.

### Bezugszeichenliste

- 1: Leiter 1
- 2: Leiter 2
- 3: Leiter 3
- 4.1 / 4.2 / 4.3: Hall-Sensoren
- 5.1 / 5.2 / 5.3: Sensoren zur Erfassung des elektrischen Feldes eines einzelnen Leiters (1, 2, 3)
- 6: Sensor zur Erfassung des summarischen elektrischen Feldes der Leiter (1, 2, 3)

## Patentansprüche

1. Vorrichtung zur Diagnose einer mittels eines Elektromotors angetriebenen mechanischen Anlage, umfassend mindestens einen Sensor zur Erfassung des Stromverlaufes in einem Leiter (1, 2, 3) des elektrischen Anschlusses des Elektromotors, sowie Sensoren zur Erfassung der Spannungsverläufe in den Leitern des elektrischen Anschlusses des Elektromotors, wobei jedem Leiter (1, 2, 3) jeweils ein Sensor (4.1, 4.2, 4.3) zur Erfassung des Stromverlaufes sowie ein Sensor (5.1, 5.2, 5.3) zur Erfassung des Spannungsverlaufes zugeordnet sind und wobei jeder Sensor (5.1, 5.2, 5.3) zur Erfassung des Spannungsverlaufes als berührungsloser Sensor zur Erfassung des elektrischen Feldes um den jeweiligen Leiter ausgeführt ist,
**dadurch gekennzeichnet, dass**
die Vorrichtung des Weiteren einen Sensor (6) zur Erfassung des summarischen elektrischen Feldes aller Leiter des elektrischen Anschlusses des Elektromotors aufweist.

2. Antriebssystem für eine Schienenweiche, umfassend mindestens einen elektrisch antreibbaren Motor sowie eine Vorrichtung zur Diagnose nach dem Patentanspruch 1.

3. Antriebssystem für eine Förderanlage, umfassend mindestens einen elektrisch antreibbaren Motor sowie eine Vorrichtung zur Diagnose nach dem Patentanspruch 1.

## Claims

1. Device for diagnosing a mechanical system which is driven by means of an electric drive motor, comprising at least one sensor for detecting the current course in a conductor (1, 2, 3) of the electrical connection of the electric drive motor, as well as
sensors for detecting the voltage curves in the conductors of the electrical connection of the electric drive motor, wherein each conductor (1, 2, 3) is assigned in each case one sensor (4.1, 4.2, 4.3) for detecting the current curve as well as one sensor (5.1, 5.2, 5.3) for detecting the voltage curve and wherein each sensor (5.1, 5.2, 5.3) for detecting the voltage curve is designed as a contactless sensor for detecting the electrical field about the respective conductor,
**characterised in that** the device furthermore has a sensor (6) for detecting the total electrical field of all conductors of the electrical connection of the electric drive motor.

2. Drive system for a track switch, comprising at least one electrically drivable motor and a device for diagnosing according to claim 1.

3. Drive system for a conveying system, comprising at least one electrically drivable motor and a device for diagnosing according to claim 1.

## Revendications

1. Dispositif de diagnostic d'une installation mécanique entraînée au moyen d'un moteur électrique, comprenant au moins un capteur pour la détection du trajet du courant dans un conducteur (1, 2, 3) du raccord électrique du moteur électrique, ainsi que
des capteurs pour la détection des courbes de tension dans les conducteurs du raccord électrique du moteur électrique, dans lequel à chaque conducteur (1, 2, 3) sont associés respectivement un capteur (4.1, 4.2, 4.3) pour la détection du trajet du courant ainsi qu'un capteur (5.1, 5.2, 5.3) pour la détection de la courbe de tension et dans lequel chaque capteur (5.1, 5.2, 5.3) est réalisé pour la détection de la courbe de tension comme capteur sans contact pour la détection du champ électrique autour du conducteur respectif,
**caractérisé en ce que** le dispositif présente en outre un capteur (6) pour la détection du champ électrique sommaire de tous les conducteurs du raccord électrique du moteur électrique.

2. Système d'entraînement pour un aiguillage ferroviaire, comprenant au moins un moteur entraînable électriquement ainsi qu'un dispositif de diagnostic selon la revendication 1.

3. Système d'entraînement pour une installation de transport, comprenant au moins un moteur entraînable électriquement ainsi qu'un dispositif de diagnostic selon la revendication 1.
